# FASCICULE DE BREVET EUROPEEN

(11) **EP 3 793 045 B1**
(45) Date de publication et mention de la délivrance du brevet: **08.06.2022**
(21) Numéro de dépôt: 20193484.1
(22) Date de dépôt: 28.08.2020
(51) Int. Cl.: H01S 5/02, H01S 5/022, H01S 5/026, H01S 5/10, H01S 5/12, H01S 5/125, H01S 5/14

(54) **CIRCUIT PHOTONIQUE À SECTION ACTIVE HYBRIDE III-V SUR SILICIUM À TAPER SILICIUM INVERSÉ**
PHOTONISCHE SCHALTUNG MIT HYBRIDEM AKTIVEM III-V-ABSCHNITT AUF SILIZIUM UND INVERTIERTEM SILIZIUMTAPER
PHOTONIC CIRCUIT WITH ACTIVE HYBRID III-V SECTION ON SILICON WITH INVERTED SILICON TAPER

(30) Priorité: 12.09.2019 FR 1910101
(43) Date de publication de la demande: 17.03.2021
(73) Titulaire: Commissariat à l'énergie atomique et aux énergies alternatives, 75015 Paris (FR)
(72) Inventeur: VEROLET, Théo, 91767 PALAISEAU (FR); GALLET, Antonin, 75014 PARIS (FR)
(74) Mandataire: Brevalex

(56) Documents cités:
- EP-A1- 3 352 312
- WO-A1-03/102678
- US-A1- 2015 132 002
- US-A1- 2017 098 922
- US-B1- 9 941 664
- KEYVANINIA S ET AL: "Heterogeneously integrated III-V/silicon distributed feedback lasers", OPTICS LETTERS, OPTICAL SOCIETY OF AMERICA, US, vol. 38, no. 24, 15 décembre 2013 (2013-12-15), pages 5434-5437, XP001587456, ISSN: 0146-9592, DOI: 10.1364/OL.38.005434 [extrait le 2013-12-12]
- FANG A W ET AL: "A Distributed Bragg Reflector Silicon Evanescent Laser", IEEE PHOTONICS TECHNOLOGY LETTERS, IEEE SERVICE CENTER, PISCATAWAY, NJ, US, vol. 20, no. 20, 15 octobre 2008 (2008-10-15), pages 1667-1669, XP011233300, ISSN: 1041-1135, DOI: 10.1109/LPT.2008.2003382

## Description

### DOMAINE TECHNIQUE

Le domaine de l'invention est celui des circuits photoniques intégrés qui utilisent à la fois les propriétés des matériaux semi-conducteurs aptes à émettre de la lumière et celles des matériaux semi-conducteurs classiquement utilisés en micro-électronique.

L'invention concerne un composant photonique à section active hydride III-V sur silicium ou silicium-germanium et porte plus particulièrement sur la conception des zones de transition modale entre la section active hybride et des sections passives de propagation purement en silicium ou en silicium-germanium.

### TECHNIQUE ANTÉRIEURE

La technologie d'intégration hétérogène de matériaux III-V avec du silicium permet de réaliser des composants optoélectroniques qui intègrent des circuits photoniques associant des sources optiques III-V avec des composants à base de silicium.

L'intégration hétérogène III-V sur silicium peut notamment consister à coller une portion de matériau actif III-V capable d'émettre de la lumière sur un circuit « passif » gravé à la surface d'un substrat silicium sur isolant SOI (« Silicon On Insulator »). Un circuit photonique à section active hybride III-V sur silicium comprend ainsi généralement :
- un substrat SOI portant un guide d'onde silicium,
- une structure à gain qui comporte au moins un milieu amplificateur optique à hétérostructure III-V, rapportée par collage sur le substrat SOI,
- une fine couche d'oxyde servant de couche de liaison et qui sépare la structure à gain du guide d'onde silicium.

L'hétérostructure III-V est agencée de manière à être sus-jacente à une section du guide d'onde silicium pour former avec celui-ci une section de guide d'onde hybride. Au niveau de cette section de guide d'onde hydride, la proximité verticale des guides III-V et silicium entraine l'apparition d'un mode optique couplé, issu de l'hybridation entre les modes propres fondamentaux de chacun de ces guides. Ce mode couplé doit être transféré depuis la section active hybride III-V/Silicium vers des sections passives de propagation de la lumière purement en silicium. Le guide d'onde en silicium est à cet effet structuré pour présenter une section de transition modale (*taper*) entre la section active hybride et les sections de propagation. Un *taper* de l'état de l'art réalise une transition adiabatique du mode symétrique entre deux états au moyen d'un rétrécissement progressif du guide d'onde silicium depuis une section de propagation vers la section active hydride.

Avant de venir coller la portion de matériau actif III-V sur le substrat SOI, une couche d'oxyde épaisse (de l'ordre du micromètre) est déposée sur le guide d'onde silicium et une planarisation chimico-mécanique (CMP pour « Chemical Mechanical Planarisation ») est effectuée pour amincir la couche d'oxyde vers une épaisseur cible de 80 nm par exemple. Il s'avère toutefois difficile d'atteindre cette épaisseur cible en tout point d'un substrat SOI qui peut présenter un diamètre de 200 mm, voire de 300 mm. L'épaisseur de la fine couche d'oxyde présente ainsi des disparités et peut varier de 30 à 130 nm sur l'intégralité de la surface du substrat SOI.

Les propriétés d'un *taper* de l'état de l'art varient cependant fortement en fonction de l'épaisseur de la couche d'oxyde. Dès lors, pour garantir que des composants hydrides présentent des propriétés escomptées identiques (par exemple une longueur d'onde d'émission pour un laser à rétroaction répartie, connu sous l'acronyme DFB pour « Distributed Feedback Laser» en anglais), des portions de matériau actif III-V ne sont collées qu'en certaines localisations du substrat SOI, en l'occurrence des localisations où l'épaisseur d'oxyde mesurée correspond à l'épaisseur cible. Il en découle qu'une part importante du substrat SOI n'est pas utilisée (par exemple jusqu'à 60% de sa surface), entraînant un surcoût.

### EXPOSÉ DE L'INVENTION

L'invention a pour objectif de proposer une solution de transition modale qui soit moins sensible aux conditions de fabrication d'un circuit photonique à section active hybride III-V sur silicium ou silicium-germanium. Elle vise plus particulièrement à répondre aux problèmes associés à la non-uniformité de la couche d'oxyde séparant le matériau III-V du guide d'onde silicium ou silicium-germanium pour permettre une industrialisation plus avancée des sources laser III-V sur silicium ou silicium-germanium.

A cet effet, l'invention propose un circuit photonique tel que défini à la revendication 1.

Certains aspects préférés mais non limitatifs de ce circuit photonique sont définis dans les revendications dépendantes.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
La figure 1 est une vue en coupe longitudinale d'un circuit photonique à section active hybride III-V sur silicium formant ici un laser DFB ;
La figure 2 est une vue de dessus d'une section de transition modale de l'état de l'art qui réalise un couplage du mode symétrique entre guide silicium passif et guide III-V actif;
La figure 3 illustre la variation d'indice effectif au sein de la section de transition modale de la figure 2 ;
La figure 4 représente le confinement du mode optique symétrique dans le guide silicium passif;
La figure 5 représente le confinement du mode optique symétrique dans le guide III-V actif ;
La figure 6 est une vue de dessus d'une section de transition modale selon l'invention qui réalise un couplage du mode antisymétrique entre guide silicium passif et guide III-V actif ;
La figure 7 illustre la variation d'indice effectif au sein de la section de transition modale de la figure 6 ;
La figure 8 représente le confinement du mode optique antisymétrique dans le guide silicium passif;
La figure 9 représente le confinement du mode optique antisymétrique dans le guide III-V actif ;
La figure 10 représente, pour différentes épaisseurs d'oxyde, la variation du taux de confinement de chacun des modes symétrique et antisymétrique à l'intérieur du milieu amplificateur en fonction de la largeur du guide d'onde silicium ;
La figure 11 représente, pour différentes épaisseurs d'oxyde, la variation de l'indice effectif de chacun des modes symétrique et antisymétrique en fonction de la largeur du guide d'onde silicium.

### DESCRIPTION DÉTAILLÉE

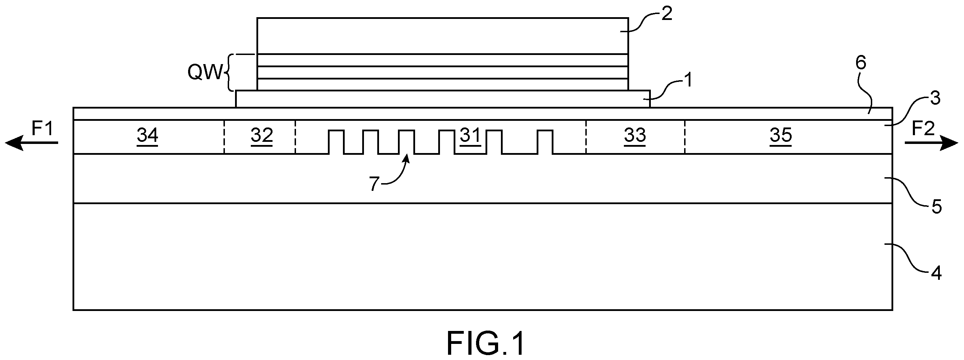

On a représenté sur la figure 1 une vue en coupe longitudinale d'un circuit photonique à section active hybride III-V sur silicium selon l'invention, formant ici un laser DFB. Ce laser DFB comprend un milieu amplificateur à hétérostructure III-V. Par hétérostructure de type III- V, on entend l'utilisation de matériaux pouvant être choisis dans la liste non exhaustive suivante : InP, GaAs, InGaAIAs, InGaAsP, AIGaAs, InAsP. L'hétérostructure d'un tel milieu amplificateur, aussi appelé milieu à gain, peut comporter un empilement de diverses couches, comme par exemple un empilement de couches formant des puits quantiques pris en sandwich entre une première couche dopée, de préférence dopée N, et une seconde couche dopée, de préférence dopée P. Un tel milieu amplificateur peut ainsi comprendre un empilement QW de puits quantiques pris en sandwich entre une couche d'InP dopée N 1 et une couche d'InP dopée P 2. L'épaisseur du sandwich constitué par les couches 1 et 2 et l'empilement de puits quantiques QW est typiquement comprise entre 1 et 3 µm.

Le milieu amplificateur à hétérostructure III-V est rapporté sur un substrat SOI qui comprend une couche superficielle 3 séparée d'un substrat massif de silicium 4 par une couche d'oxyde enterrée 5. Un guide optique est structuré dans la couche superficielle 3 et une couche de liaison en un oxyde 6 vient séparer le milieu amplificateur du guide d'onde. La couche superficielle 3 peut être en silicium ou en silicium-germanium, et on parle donc d'un guide d'onde silicium ou d'un guide d'onde silicium-germanium. On prendra dans ce qui suit l'exemple d'un guide d'onde silicium, étant entendu que l'exposé peut tout à fait être transposé à un guide d'onde silicium-germanium.

Comme représenté sur la figure 1, le guide d'onde, silicium dans l'exemple, est localement en regard du milieu amplificateur au niveau d'une zone de recouvrement. Le guide d'onde optique comprend plus particulièrement une section de couplage 31 en regard d'une portion centrale du milieu amplificateur, deux sections de transition modale 32, 33 agencées de part et d'autre de la section de couplage 31 à une extrémité de la zone de recouvrement (chacune se retrouvant ainsi en regard d'une extrémité du milieu amplificateur) et, à l'extérieur de la zone de recouvrement, deux sections de propagation 34, 35, chacune optiquement couplée à l'une des sections de transition modale 32, 33 et non recouverte par le milieu amplificateur.

Un réseau de Bragg 7 est formé dans la section de couplage 41 pour fournir une rétroaction optique permettant de former une cavité résonante pour le milieu amplificateur. La lumière issue de la cavité laser est ainsi couplée avec le guide en silicium et se propage en sortie selon les flèches F1 et F2 depuis chacune des sections de propagation 34, 35.

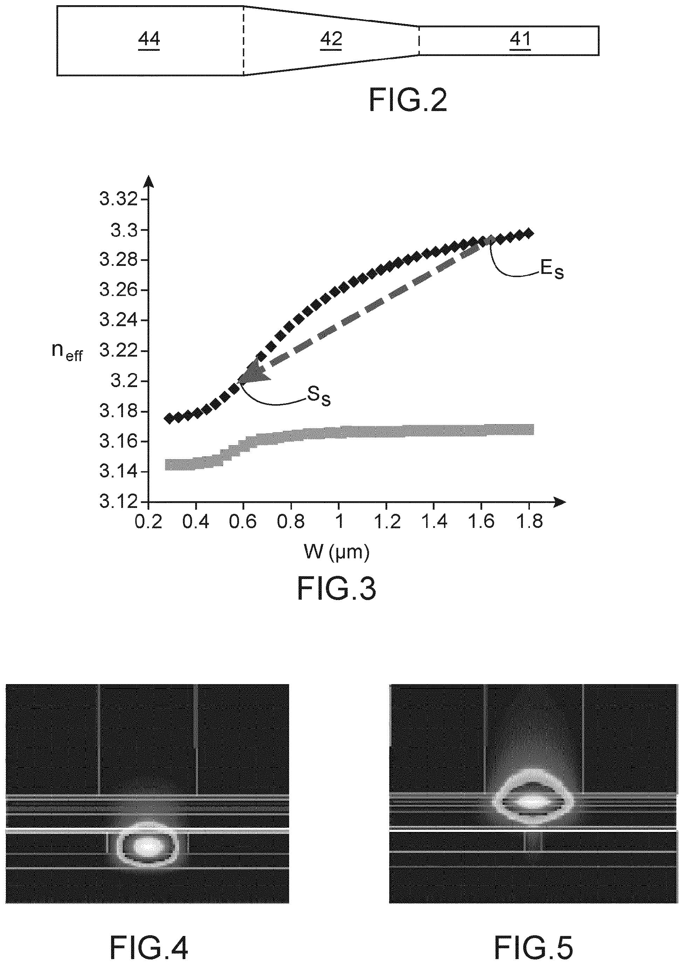

On a représenté sur la figure 2 une section de transition modale 42 de l'état de l'art qui réalise un couplage du mode optique symétrique entre guide silicium passif et guide III-V actif. Cette section de transition modale 42 va en se rétrécissant, transversalement à la direction de propagation de la lumière, depuis une section passive de propagation de la lumière en silicium 44 vers une section de couplage 41 avec le milieu amplificateur III-V. En d'autres termes, cette section de transition 42 est réalisée en diminuant la largeur du guide silicium depuis la section passive 44 vers la section active hybride 41.

La figure 3 illustre l'indice effectif n_{eff} du mode symétrique en fonction de la largeur W (en nm) d'un guide d'onde silicium transversalement à la direction de propagation de la lumière. Cette figure 3 explique la diminution de l'indice effectif n_{eff} au sein de la section de transition modale 42 de la figure 2 depuis une entrée Es côté section de propagation 44 vers une sortie Ss côté section de couplage 41. Cette diminution permet de passer d'un confinement du mode optique symétrique principalement dans la section de propagation 44 du guide passif silicium comme représenté sur la figure 4 à un confinement du mode optique symétrique principalement dans le guide III-V actif comme représenté sur la figure 5.

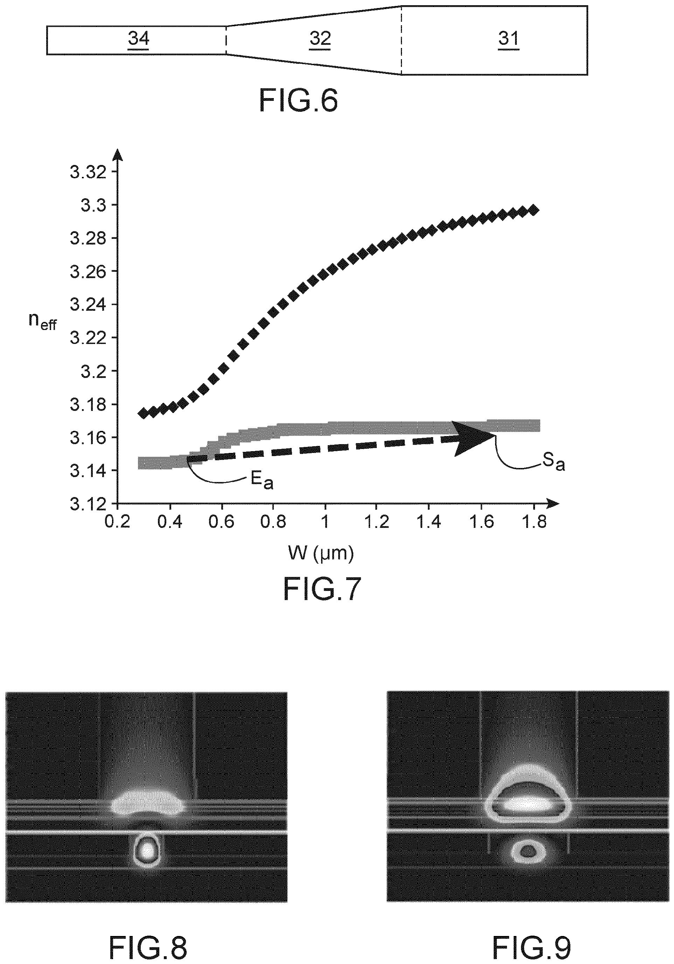

Par contraste à une telle section de transition modale de l'état de l'art, l'invention préconise de réaliser un couplage du mode antisymétrique entre guide silicium passif et guide III-V actif au moyen d'une section de transition modale qui réalise une transition adiabatique du mode antisymétrique entre deux états. Une telle section de transition modale 32 selon l'invention est représentée sur la figure 6. Comme représenté, elle va en s'élargissant, transversalement à la direction de propagation de la lumière, sur toute sa longueur (le long de la direction de propagation de la lumière) depuis une section passive de propagation de la lumière en silicium 34 jusqu'à la section de couplage 31 avec le milieu amplificateur III-V. En d'autres termes, cette section de transition 32 est réalisée en augmentant sur toute sa longueur la largeur du guide silicium depuis la section passive 34 vers la section active hybride 31. À titre d'exemple, la largeur initiale de la section de transition 32 (côté section passive 34) est comprise entre 300 nm et 600 nm, de préférence 400nm, et la largeur finale de la section de transition 32 (côté section de couplage 31) est comprise entre 1 µm et 2 µm, de préférence 1,5 µm. La longueur de la section de transition 32 peut quant à elle être comprise entre 50 µm et 300 µm, de préférence entre 100 µm et 200 µm, par exemple de 150 µm. L'élargissement du guide d'onde dans la section de transition depuis la section passive 34 vers la section active hybride 31 suit un profil permettant une transformation adiabatique optimale du mode antisymétrique. Ce profil est par exemple du type arc tangente.

La figure 7 illustre l'indice effectif n_{eff} du mode antisymétrique en fonction de la larguer W (en nm) d'un guide d'onde silicium transversalement à la direction de propagation de la lumière. Cette figure 7 explique l'augmentation de l'indice effectif n_{eff} au sein de la section de transition modale 32 selon l'invention depuis une entrée Ea côté section de propagation 44 vers une sortie Sa côté section de couplage 41. Cette augmentation permet de passer d'un confinement du mode optique antisymétrique principalement dans la section de propagation 34 du guide silicium comme représenté sur la figure 8 à un confinement du mode optique antisymétrique principalement dans le guide III-V actif comme représenté sur la figure 9. Un confinement du mode optique antisymétrique dans la section de propagation 34 peut notamment être assuré en prévoyant une largeur du guide d'onde silicium dans cette section 34 inférieure à 400 nm. L'élargissement du guide silicium dans la section de transition modale 32 permet de progressivement transférer la lumière au milieu III-V.

Le mode antisymétrique présente l'avantage d'être nettement plus robuste que le mode symétrique aux variations de l'épaisseur de la couche d'oxyde 6 servant de liaison entre le III-V et le Si. Ainsi les disparités de cette épaisseur entre 30 et 130 nm sur un substrat de 200 mm de diamètre sont nettement moins préjudiciables à une section de transition modale selon l'invention. Comme les propriétés de ces sections sont cruciales à la réalisation de sources laser III-V sur silicium ou silicium-germanium, de telles sources mettant en oeuvre un circuit selon l'invention sont également bien plus robustes aux variations de l'épaisseur de la couche de collage 6 et le rendement de ces sources est donc accru.

La robustesse du mode antisymétrique aux variations de l'épaisseur de la couche de d'oxyde 6 a été étudiée en examinant différentes propriétés de ce mode : son facteur de confinement, son indice effectif, la force de couplage du réseau de Bragg d'un laser DFB et le fonctionnement du laser DFB à haute température.

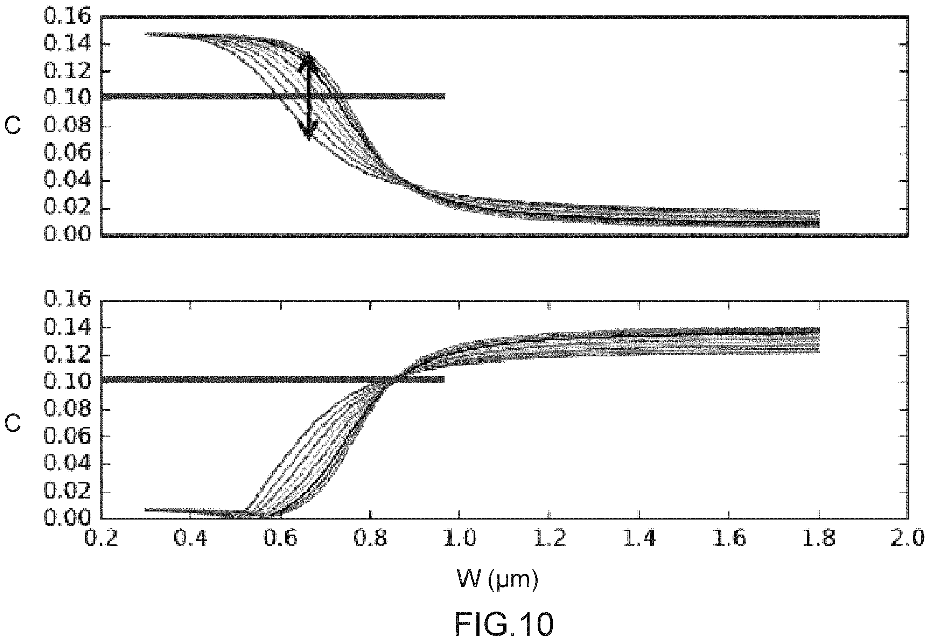

La figure 10 représente ainsi, pour différentes épaisseurs de la couche d'oxyde (de 30 nm à 130 nm), la variation du taux de confinement C de chacun des modes symétrique (en haut sur la figure 10) et antisymétrique (en bas sur la figure 10) en fonction de la largeur W (en nm) du guide d'onde silicium dans la section de couplage 31. On constate, pour une valeur de 10% classiquement désirée pour le confinement, aucune variation du confinement du mode antisymétrique en fonction de l'épaisseur de la couche d'oxyde là où le confinement du mode symétrique varie entre 6% et 14% en fonction de l'épaisseur de la couche d'oxyde.

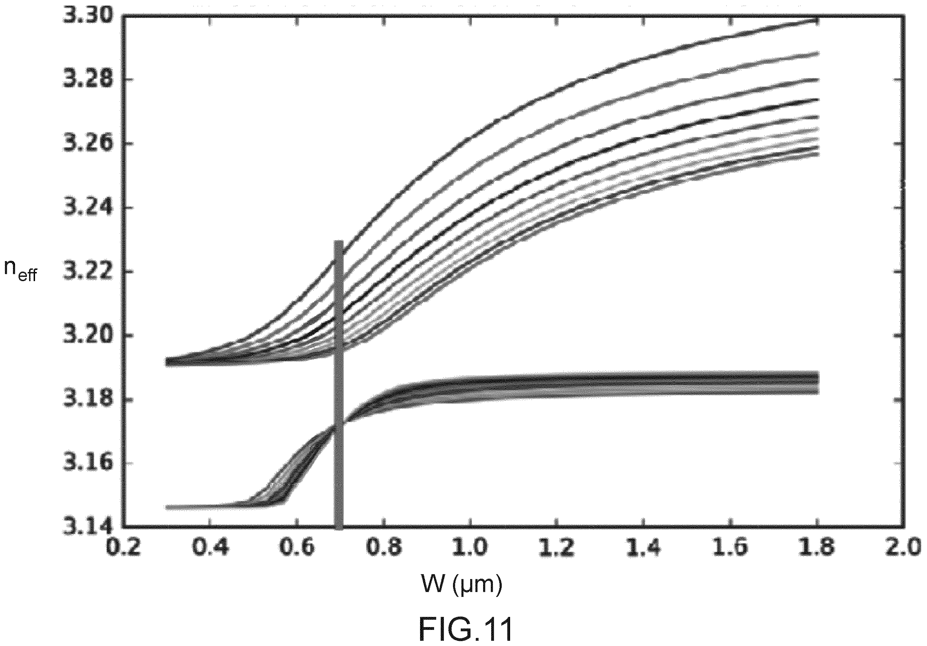

La figure 11 représente quant à elle, pour différentes épaisseurs de la couche d'oxyde (de 30 nm à 130 nm), la variation de l'indice effectif n_{eff} de chacun des modes symétrique (en haut sur la figure 11) et antisymétrique (en bas sur la figure 11) en fonction de la largeur W (en nm) du guide d'onde silicium dans la section de couplage 31. On constate que l'indice effectif du mode antisymétrique est nettement plus robuste aux variations de l'épaisseur de la couche d'oxyde que celui du mode symétrique. À titre d'exemple, pour une largeur du guide silicium de 0,7 µm, cet indice est susceptible de varier entre 3,195 et 3,220 pour le mode symétrique là où il est invariant pour le mode anti-symétrique. Dès lors, la longueur d'onde d'émission d'un laser réalisé selon l'invention est robuste aux variations d'épaisseur de la couche d'oxyde.

Dans un laser DFB, la force de couplage du réseau de Bragg pratiqué dans la section de couplage 31 est fortement impactée par l'épaisseur de la couche d'oxyde 6 dans le cas d'une propagation du mode symétrique. Ce n'est pas le cas en revanche dans le cas d'une propagation du mode antisymétrique.

On relèvera par ailleurs que puisque l'indice effectif du mode antisymétrique est inférieur à celui du mode symétrique, un laser DFB exploitant le mode antisymétrique émet à une longueur d'onde inférieure à celle à laquelle émet un laser DFB exploitant le mode symétrique. Pour obtenir un fonctionnement correct du laser à haute température, il est nécessaire d'en décaler la longueur d'onde d'émission vers le pic de photoluminescence du milieu à gain III-V. Dès lors, un laser DFB exploitant le mode symétrique et dont la longueur d'onde d'émission est ainsi décalée voit son mode antisymétrique venir en correspondance avec le maximum du milieu à gain. Le ratio SMSR (« Side Mode Suppression Ratio » désignant le rapport de suppression de lobe latéral) d'un tel laser est alors faible. À contrario, un laser DFB exploitant le mode antisymétrique et dont la longueur d'onde d'émission est ainsi décalé voit alors son mode symétrique ne plus être en correspondance avec le milieu à gain. Le ratio SMSR est ainsi amélioré. Le laser DFB exploitant le mode antisymétrique est donc moins sensible aux variations de température qu'un laser DFB exploitant le mode symétrique.

On a vu précédemment que le circuit photonique selon l'invention peut exploiter une structure de rétroaction optique permettant de former une cavité résonante pour le milieu amplificateur. Cette structure de rétroaction est, comme précédemment décrit, constituée par un réflecteur distribué formé dans la section de couplage dans le cas d'un laser DFB. L'invention s'étend d'une manière générale à toute source laser à semi-conducteurs III-V, comme par exemple des sources qui utilisent pour structure de rétroaction un réflecteur disposé dans chacune des sections de propagation 34, 35 (formant ainsi un laser à réseau de Bragg distribué dit laser DBR pour « Distributed Bragg Reflector ») ou encore un anneau.

Dans un mode de réalisation possible de l'invention, le milieu amplificateur à hétérostructure III-V comprend lui aussi des sections de transition de part et d'autre de la portion centrale du milieu amplificateur, ces sections de transition visant principalement à éviter des réflexions parasites. Dans une telle section de transition, la largeur du milieu amplificateur peut progressivement diminuer de ladite portion centrale en direction des sections de propagation 34, 35 du guide silicium, en présentant éventuellement la forme d'une pointe effilée. Alternativement, cette section de transition peut prendre la forme d'un virage à pertes.

## Revendications

1. Circuit photonique, comprenant :
- un milieu amplificateur à hétérostructure III-V (1, QW, 2),
- un guide d'onde optique localement en regard du milieu amplificateur au niveau d'une zone de recouvrement, le guide d'onde optique comportant une section de couplage (31) en regard d'une portion centrale du milieu amplificateur, une section de propagation (34, 35) à l'extérieur de la zone de recouvrement et une section de transition modale (32, 33) agencée entre la section de couplage et la section de propagation à une extrémité de la zone de recouvrement,
**caractérisé en ce que** la section de transition modale du guide d'onde optique est conformée de manière à assurer un couplage du mode antisymétrique entre la section de propagation et la section de couplage en étant progressivement élargie sur toute sa longueur depuis la section de propagation jusqu'à la section de couplage.

2. Circuit photonique selon la revendication 1, dans lequel le milieu amplificateur comprend une section de transition dont la largeur diminue depuis ladite portion centrale en direction de la section de propagation.

3. Circuit photonique selon l'une des revendications 1 et 2, comprenant en outre une structure de rétroaction optique permettant de former une cavité résonante pour le milieu amplificateur.

4. Circuit photonique selon la revendication 3, dans lequel la structure de rétroaction optique est constituée par un réflecteur distribué (7) formé dans la section de couplage.

5. Circuit photonique selon la revendication 3, dans lequel la structure de rétroaction optique comprend un réflecteur disposé dans la section de propagation.

6. Circuit photonique selon la revendication 3, dans lequel la structure de rétroaction optique est un anneau.

7. Circuit photonique selon l'une des revendications 1 à 6, dans lequel le guide d'onde optique est en silicium ou en silicium-germanium.

## Patentansprüche

1. Photonische Schaltung, umfassend:
- ein Verstärkermedium mit Heterostruktur III-V (1, QW, 2),
- einen optischen Wellenleiter lokal gegenüber dem Verstärkermedium im Bereich einer überlappenden Zone, wobei der optische Wellenleiter einen Kopplungsabschnitt (31) enthält gegenüber einem zentralen Bereich des Verstärkermediums, einen Ausbreitungsabschnitt (34, 35) außerhalb der überlappenden Zone und einen Abschnitt des modalen Übergangs (32, 33), der zwischen dem Kopplungsabschnitt und dem Ausbreitungsabschnitt an einem Ende der überlappenden Zone angeordnet ist,
**dadurch gekennzeichnet, dass** der Abschnitt des modalen Übergangs des optischen Wellenleiters so ausgebildet ist, dass eine Kopplung des antisymmetrischen Modus zwischen dem Ausbreitungsabschnitt und dem Kopplungsabschnitt durch schrittweise Erweiterung über seine gesamte Länge vom Ausbreitungsabschnitt bis zum Kopplungsabschnitt gewährleistet ist.

2. Photonische Schaltung nach Anspruch 1, wobei das Verstärkermedium einen Abschnitt des Übergangs umfasst, dessen Breite vom zentralen Bereich in Richtung des Ausbreitungsabschnitts abnimmt.

3. Photonische Schaltung nach einem der Ansprüche 1 und 2, ferner eine Struktur der optischen Rückkopplung umfassend, die die Bildung eines Hohlraumresonators für das Verstärkermedium ermöglicht.

4. Photonische Schaltung nach Anspruch 3, wobei die Struktur der optischen Rückkopplung aus einem aufgeteilten Reflektor (7) besteht, der im Kopplungsabschnitt gebildet ist.

5. Photonische Schaltung nach Anspruch 3, wobei die Struktur der optischen Rückkopplung einen Reflektor umfasst, der im Ausbreitungsabschnitt angeordnet ist.

6. Photonische Schaltung nach Anspruch 3, wobei die Struktur der optischen Rückkopplung ein Ring ist.

7. Photonische Schaltung nach einem der Ansprüche 1 bis 6, wobei der optische Wellenleiter aus Silizium oder Siliziumgermanium ist.

## Claims

1. Photonic circuit, comprising:
- an amplifying medium with III-V heterostructure (1, QW, 2),
- an optical wave guide locally facing the amplifying medium at an overlap zone, the optical wave guide comprising a coupling section (31) facing a central portion of the amplifying medium, a propagation section (34, 35) outside the overlap zone and a modal transition section (32, 33) arranged between the coupling section and the propagation section at one end of the overlap zone,
**characterised in that** the modal transition section of the optical wave guide is conformed to achieve coupling of the antisymmetric mode between the propagation section and the coupling section by widening progressively over its entire length from the propagation section to the coupling section.

2. Photonic circuit according to claim 1, wherein the amplifying medium comprises a transition section, the width of which reduces from said central portion towards the propagation section.

3. Photonic circuit according to one of claims 1 or 2, also comprising an optical feedback structure making it possible to form a resonant cavity for the amplifying medium.

4. Photonic circuit according to claim 3 , wherein the optical feedback structure is composed of a distributed reflector (7) formed in the coupling section.

5. Photonic circuit according to claim 5 , wherein the optical feedback structure comprises a reflector located in the propagation section.

6. Photonic circuit according to claim 3 , wherein the optical feedback structure is a ring.

7. Photonic circuit according to one of claims 1 to 6 , wherein the optical wave guide is made of silicon or silicon-germanium.
